# FASCICULE DE BREVET EUROPEEN

(11) **EP 4 391 347 B1**
(45) Date de publication et mention de la délivrance du brevet: **08.07.2026**
(21) Numéro de dépôt: 22216410.5
(22) Date de dépôt: 23.12.2022
(51) Int. Cl.: H02N 2/00, H02N 2/10, G04C 3/12

(54) **RÉSONATEUR PIÉZOÉLECTRIQUE À GUIDAGE FLEXIBLE, NOTAMMENT POUR MOTEUR ROTATIF D'HORLOGERIE**
PIEZOELEKTRISCHER RESONATOR MIT FLEXIBLER FÜHRUNG, INSBESONDERE FÜR ROTATIONSMOTOREN VON UHRWERKEN
PIEZOELECTRIC RESONATOR WITH FLEXIBLE GUIDE, IN PARTICULAR FOR ROTARY MOTORS IN HOROLOGY

(43) Date de publication de la demande: 26.06.2024
(73) Titulaire: The Swatch Group Research and Development Ltd, 2074 Marin (CH)
(72) Inventeur: KAHROBAIYAN, Mohammad Hussein, 2043 Boudevilliers (CH); FERRI, Yvan, 1004 Lausanne (CH); DIDIER, Alexandre, 3235 Erlach (CH); PARATTE, Lionel, 2074 Marin-Epagnier (CH); BORN, Jean-Jacques, 1110 Morges (CH)
(74) Mandataire: ICB SA

(56) Documents cités:
- EP-A1- 3 451 072
- DE-A1- 1 945 448
- FR-A- 1 562 662

## Description

### Domaine technique de l'invention

L'invention se rapporte au domaine technique des résonateurs piézoélectriques, notamment pour moteur piézoélectrique rotatif. L'invention se rapporte également au domaine technique des pièces d'horlogeries munies d'un tel moteur piézoélectrique rotatif.

### Arrière-plan technologique

Les moteurs électriques usuellement utilisés en horlogerie sont des moteurs rotatifs de type « Lavet », qui fonctionnent sur des principes physiques électromagnétiques. Un tel moteur comporte généralement un stator muni de bobines et un rotor aimanté, qui tourne par actionnement déphasé des bobines.

Cependant, ces moteurs ont une résistance limitée aux champs magnétiques élevés. A partir d'une certaine valeur de champs magnétique, le moteur se bloque. En général, ils se bloquent sous l'effet d'un champ magnétique qui dépasse 2 mT.

Ainsi, pour éviter ce problème, il est nécessaire de concevoir des moteurs fonctionnant sur d'autres principes physique.

Il existe par exemple des moteurs électrostatiques à peignes, tel que celui décrit dans le brevet CH709512. Mais les peignes prennent de la place, et ils consomment une énergie plus élevée que les moteurs de type « Lavet ».

Des moteurs basés sur l'effet piézoélectrique ont aussi été mis au point, par exemple dans le brevet EP0587031. Mais celui-ci est limité à l'actionnement d'un quantième. En outre, sa consommation élevée et le risque d'usure prématurée ne permettent pas l'entraînement d'une aiguille des secondes, qui demande en général le plus d'énergie. Un résonateur piézoélectrique selon le préambule de la revendication indépendante 1 est connu à partir du brevet FR 1 562 662. Son guidage flexible de la masse oscillante comprend une seule lame flexible incluant un matériau piézoélectrique.

### Résumé de l'invention

Le but de la présente invention est de proposer un résonateur piézoélectrique, notamment pour moteur piézoélectrique rotatif, qui peut résister à des champs électromagnétiques élevés, tout en gardant une consommation d'énergie et un volume réduits.

A cet effet, l'invention se rapporte à un résonateur piézoélectrique, notamment pour moteur piézoélectrique rotatif d'une pièce d'horlogerie, selon la revendication 1, le résonateur comprenant une embase immobile et une masse oscillante s'étendant autour d'un axe longitudinal, la masse oscillante étant munie d'au moins une masselotte, de préférence deux masselottes opposées.

L'invention est remarquable en ce que qu'il comprend un guidage à lames flexibles reliant la masse oscillante à l'embase, de manière à pouvoir faire osciller la masse oscillante autour d'un centre de rotation dans un mouvement de balancier, le guidage flexible comprenant au moins une première lame flexible reliant l'embase à la masse oscillante, la première lame flexible comportant au moins en partie un matériau piézoélectrique actionnable électriquement pour déformer la première lame flexible et faire osciller la masse oscillante.

Un résonateur ayant une telle configuration permet de fournir un mouvement avec efficacité. En effet, en actionnant le matériau piézoélectrique de la ou des lames flexibles, elles se courbent, de sorte que la masse oscillante oscille en pivotant sur elle-même autour d'un centre de rotation. Ainsi, le résonateur produit un mouvement oscillatoire de la masse oscillante, tout en consommant peu d'énergie, car l'actionnement de la ou des lames flexibles demande moins d'énergie.

En outre, en choisissant des conditions de résonance du résonateur à la fréquence propre du résonateur, le résonateur piézoélectrique, et donc le moteur consomment peu d'énergie. L'actionnement à la résonance permet d'obtenir une amplitude plus importante avec peu d'énergie.

Le mouvement oscillatoire peut ainsi être transmis à d'autres pièces mécaniques selon le domaine d'application du résonateur piézoélectrique, par exemple à une roue dentée d'un mouvement.

Selon une forme de réalisation particulière de l'invention, le centre de rotation est agencé sensiblement au milieu de la masse oscillante, de préférence au centre de masse de la masse oscillante.

Selon l'invention, le guidage flexible comporte une deuxième lame flexible reliant la masse oscillante à l'embase. On obtient ainsi un pivot élastique de type RCC (pour remote center compliance), qui est un guidage élastique rotatif.

Selon une forme de réalisation particulière de l'invention, la deuxième lame flexible comporte au moins en partie un matériau piézoélectrique actionnable électriquement pour déformer la deuxième lame flexible et faire osciller la masse oscillante.

Selon une forme de réalisation particulière de l'invention, la première lame flexible et la deuxième lame flexible forment un angle compris entre 30° et 150°, de préférence entre 60° et 130°, voire entre 90° et 120°.

Selon une forme de réalisation particulière de l'invention, la première lame flexible et la deuxième lame flexible sont décroisées et s'écartent depuis une partie centrale de la masse oscillante jusqu'à des parties excentrées de l'embase.

Selon une forme de réalisation particulière de l'invention, le résonateur comprend comprenant une troisième lame flexible, la deuxième lame flexible et la troisième lame flexible étant décroisées et s'écartent depuis une partie centrale de la masse oscillante jusqu'à des parties excentrées de l'embase.

Selon une forme de réalisation particulière de l'invention, la deuxième lame flexible et la troisième lame flexible forment un angle compris entre 30° et 150°, de préférence entre 60° et 130°, voire entre 90° et 120°.

Selon une forme de réalisation particulière de l'invention, la première lame flexible est agencée entre la deuxième lame flexible et la troisième lame flexible.

Selon une forme de réalisation particulière de l'invention, la première lame flexible est plus proche de la deuxième lame flexible que de la troisième lame flexible.

Selon une forme de réalisation particulière de l'invention, la première lame flexible comprend une portion rigide.

Selon une forme de réalisation particulière de l'invention, la masse oscillante comprend une masselotte repliée en forme de coude.

Selon une forme de réalisation particulière de l'invention, la première lame flexible est oblique et reliée à l'extrémité de la masselotte repliée en forme de coude.

Selon une forme de réalisation particulière de l'invention, la deuxième lame flexible est sensiblement parallèle à l'axe longitudinal de la masse oscillante, et est reliée à l'intérieur du coude de la masselotte.

Selon une forme de réalisation particulière de l'invention, la première lame flexible et la deuxième lame flexible forment un angle compris entre 10 et 90°, de préférence entre 30° et 60°.

Selon une forme de réalisation particulière de l'invention, la deuxième lame flexible est agencée d'un côté opposé à la première lame flexible par rapport à la masse oscillante.

Selon une forme de réalisation particulière de l'invention, le résonateur piézoélectrique est agencé sensiblement dans un même plan.

Selon une forme de réalisation particulière de l'invention, le résonateur est configuré pour faire osciller la masse à la fréquence propre du résonateur.

Selon une forme de réalisation particulière de l'invention, le résonateur comporte, de préférence majoritairement, un matériau mono-cristallin ou poly-cristallin amagnétique et de basse conductivité, tels que le silicium, le verre, la céramique, ou un métal, et est obtenu par exemple par un procédé photo-lithographique de micro-usinage de type MEMS.

Selon une forme de réalisation particulière de l'invention, le guidage flexible est monobloc.

L'invention se rapporte également à un moteur piézoélectrique, notamment pour un dispositif d'affichage d'une pièce d'horlogerie, comprenant un tel résonateur piézoélectrique.

Selon une forme de réalisation particulière de l'invention, le moteur piézoélectrique comprend au moins un cliquet, de préférence deux cliquets, et une roue mobile, le cliquet étant monté sur la masse oscillante du résonateur piézoélectrique, de manière à faire tourner la roue mobile dans un premier sens, lorsque la masse oscillante effectue ses oscillations.

L'invention se rapporte encore à une pièce d'horlogerie comportant un mouvement d'horlogerie comprenant une transmission d'engrenages configurée pour faire tourner au moins une aiguille, et comprenant un tel moteur piézoélectrique agencé pour actionner la transmission d'engrenages.

### Brève description des figures

D'autres particularités et avantages ressortiront clairement de la description qui en est faite ci-après, à titre indicatif et nullement limitatif, en référence aux dessins annexés, dans lesquels :
- la figure 1 représente schématiquement une vue en perspective de dessus d'un premier mode de réalisation d'un résonateur piézoélectrique, notamment pour moteur rotatif, selon l'invention,
- la figure 2 représente schématiquement une vue en perspective de dessus d'un deuxième mode de réalisation d'un résonateur piézoélectrique, notamment pour moteur rotatif, selon l'invention,
- la figure 3 représente schématiquement une vue de dessus d'un troisième mode de réalisation d'un résonateur piézoélectrique, notamment pour moteur rotatif, selon l'invention,
- la figure 4 représente schématiquement une vue de dessus d'une partie troisième mode de réalisation du résonateur piézoélectrique,
- la figure 5 représente schématiquement une vue de dessus d'un quatrième mode de réalisation d'un résonateur piézoélectrique, notamment pour moteur rotatif, selon l'invention,
- la figure 6 représente schématiquement une vue en perspective de dessus d'un cinquième mode de réalisation d'un résonateur piézoélectrique, notamment pour moteur rotatif, en dehors de l'invention, et
- la figure 7 représente schématiquement une vue de dessus d'un moteur piézoélectrique rotatif comprenant un résonateur selon l'invention.

### Description détaillée de l'invention

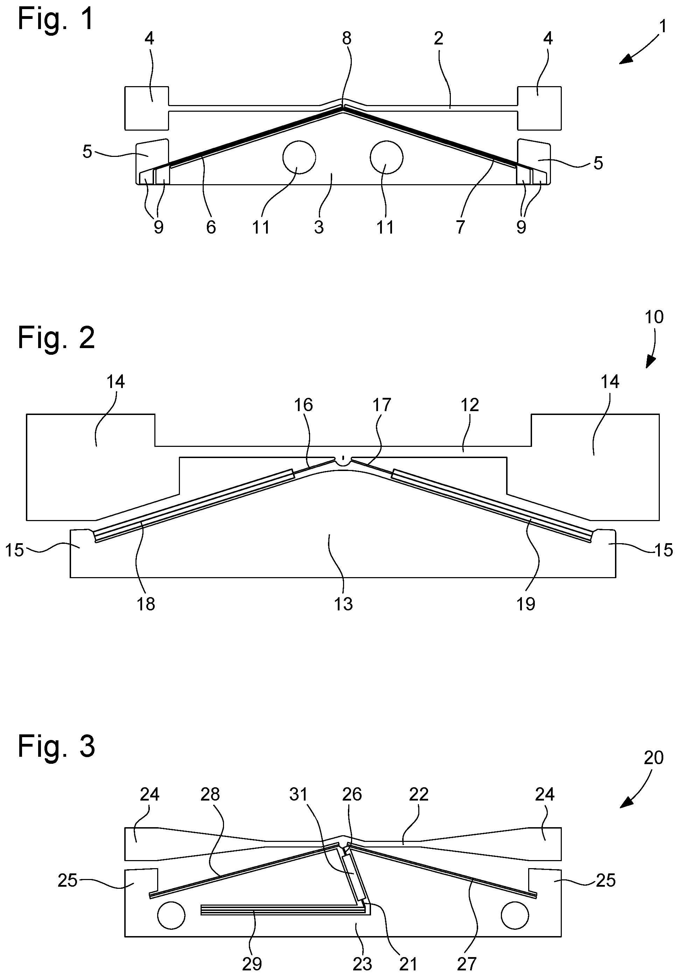

Les figures 1 à 6 montrent des modes de réalisation différents d'un résonateur piézoélectrique, notamment utilisé dans un moteur rotatif. Le moteur peut notamment servir dans une pièce d'horlogerie pour actionner un dispositif d'affichage comprenant des aiguilles agencées sur un cadran. Le résonateur piézoélectrique 1, 10, 20, 30, 40 s'étend de préférence sensiblement dans un plan.

Sur la figure 1, le premier mode de réalisation de résonateur piézoélectrique comprend une embase 3, qui a ici une forme sensiblement triangulaire, de préférence isocèle. L'embase 3 comporte deux trous 11 pour pouvoir assembler l'embase sur une platine ou sur un pont, en particulier dans un mouvement d'horlogerie.

Le triangle a un sommet principal et deux sommets opposés excentrés. Le triangle a ici deux cotés égaux et une base de longueur supérieure à la hauteur, de préférence au moins deux fois supérieure, voire quatre ou cinq fois supérieure. Les deux sommets opposés comportent chacun une excroissance 5 s'étendant ver le haut du triangle.

Le résonateur 1 comprend en outre une masse oscillante 2. La masse oscillante 2 comprend un bras principal aux extrémités duquel sont agencées deux masselottes 4. Le bras comprend un plot 8 agencé en son milieu et orienté vers l'embase 3. Le bras est disposé tangentiellement au sommet principal du triangle. Le bras est sensiblement droit, excepté au milieu où il forme un décrochement triangulaire pour correspondre au sommet principal du triangle. Le plot 8 est agencé à l'intérieur du décrochement triangulaire.

La masse oscillante 2 et l'embase 3 sont agencées de préférence dans un même plan.

Selon l'invention, le résonateur comprend un guidage à lames flexibles reliant la masse oscillante 2 à l'embase 3, de manière à pouvoir faire osciller la masse oscillante 2 autour d'un centre de rotation dans un mouvement de balancier. Le centre de rotation est agencé sensiblement au milieu de la masse oscillante 2, c'est-à-dire au milieu du bras, de préférence au centre de masse de la masse oscillante 2. On obtient ainsi un pivot élastique de type RCC (pour remote center compliance), qui est un guidage élastique rotatif.

Le guidage flexible comprend deux lames flexibles. Une première lame flexible 6 et une deuxième lame flexible 7 sont reliées à une même partie centrale de la masse oscillante 2, ici le plot 8. La première lame flexible 6 et la deuxième lame flexible 7 sont en outre reliées à deux parties opposés excentrées de l'embase 3, ici les deux excroissances 5.

La première lame flexible 6 et la deuxième lame flexible 7 sont décroisées et s'écartent depuis le plot 8 de la masse oscillante 2 jusqu'aux excroissances 5 de l'embase 3. Ainsi, chaque lame flexible 6, 7 relie une excroissance 5 de l'embase 3 au plot 8 de la masse oscillante, en longeant un des côtés égaux du triangle isocèle.

La première 6 et la deuxième lame flexible 7 forment un angle non nul entre elles, l'angle étant compris entre 30° et 150°, de préférence entre 60° et 130°, voire entre 90° et 120°.

Les lames flexibles 6, 7 comportent chacune un matériau piézoélectrique, qui est actionnable pour actionner les lames flexibles et faire osciller la masse oscillante par rapport à l'embase. De préférence, le matériau piézoélectrique piézoélectriques est agencé sur chaque lame flexible 6, 7 en entier.

Les lames flexibles ont par exemple une couche de matériau piézoélectrique prise en sandwich entre deux couches d'électrodes.

Pour actionner les lames flexibles 6, 7, les excroissances 5 comprennent plusieurs contacts électriques 9 reliés aux couches d'électrodes pour recevoir une tension électrique et actionner les couches piézoélectriques des lames flexibles.

Les couches piézoélectriques sont de préférence formées d'un matériau cristallin ou polycristallin, par exemple en céramique de type KNN (pour niobate de Potassium sodium) ou de type PZT (pour titano-zirconates de plomb, les lames flexibles 6, 7 ayant une épaisseur leur permettant de se déformer.

Ainsi, en activant électriquement les couches de matériau piézoélectrique, les lames flexibles 6, 7 se déforment alternativement latéralement en direction du centre et de l'extérieur. L'activation est produite avec une tension alternative.

En choisissant un actionnement des deux lames flexibles 6, 7 en opposition de phase, par inversion de polarité d'une lame à l'autre, la masse oscillante effectue de petites oscillations autour du centre de rotation correspondant au point de croisement des deux lames flexibles, ici au niveau du plot 8. Ainsi, la masse oscillante 2 oscille et les deux masselottes 4 se déplacent latéralement à une certaine fréquence, de préférence à la fréquence de résonance.

Dans le deuxième mode réalisation de résonateur 10 de la figure 2, des cols flexibles plus étroits que les lames sont ajoutées. Le matériau piézoélectrique est alors seulement situé sur une partie 18, 19 de la longueur des lames flexibles 16, 17. Le reste du résonateur 10 est sensiblement identique au mode de réalisation précédent. Ainsi, la partie des lames 16, 17 sans matériau piézoélectrique est plus mince que la partie avec matériau piézoélectrique, de préférence cinq à dix fois plus mince.

L'embase 13 et les excroissances 25 sont sensiblement identiques au premier mode de réalisation.

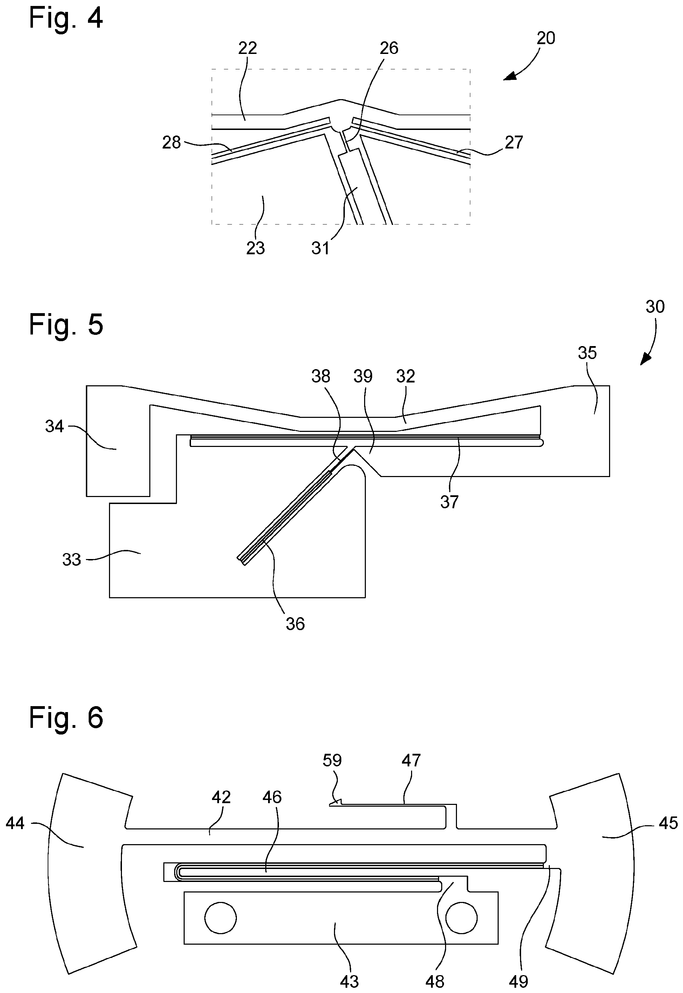

Le troisième mode de réalisation d'un résonateur 20 des figures 3 et 4, montre un résonateur muni d'un guidage flexible à trois lames flexibles 26, 27, 28. Le résonateur est semblable aux deux premiers modes de réalisation concernant la forme de l'embase 23 et les excroissances 25.

L'embase 23 comprend un canal 21 ouvert depuis le sommet principal jusqu'à l'intérieur de l'embase 23. La canal 21 forme un coude dans l'embase 23.

Une première lame flexible 26 relie le plot de la masse oscillante 22 à l'embase 23 entre la deuxième 27 et la troisième lame flexible 28.

La deuxième 27 et la troisième lame flexible 28 sont agencées comme les lames flexibles du premier du deuxième mode de réalisation. Elles forment un angle non nul entre elles, l'angle étant compris entre 30° et 150°, de préférence entre 60° et 130°, voire entre 90° e 120°, la première lame flexible. Dans ce mode de réalisation, ces deux lames flexibles ne comprennent pas de matériau piézoélectrique. La deuxième 27 et la troisième la lame flexible 28 sont reliées à une même partie centrale de la masse oscillante 22 et à deux excroissances 25 opposées excentrées de l'embase 23. La deuxième 27 et la troisième lame 28 sont décroisées et s'écartent depuis la partie centrale, ici un plot de la masse oscillante 22 jusqu'aux parties excentrées de l'embase 23.

L'actionnement de la première lame flexible 26 est effectuée grâce à des contacts électriques montés sur l'embase 23, non représentés sur les figures.

La première lame flexible 26 s'étend dans la canal coudé 21 jusqu'à un point de fixation au fond du canal 21. La première lame flexible 26 comprend une portion 29 munie du matériau piézoélectrique au fond du canal 21 après le coude, et une portion rigide 31 à l'entrée du canal 21. Les deux portions 29, 31 sont séparées par un col flexible agencé au coude.

La figure 4 est un agrandissement de la figure 3, la zone centrale de la première lame flexible 26 étant excentrée d'une distance r non nulle par rapport au point de croisement de la deuxième 27 et de la troisième lame flexible 28, de sorte que lorsque la première lame flexible 26 est actionnée, alternativement, elle tire la masse oscillante 22 d'un côté, puis le relâche pour le faire osciller autour d'un centre de rotation passant par le point de croisement des deux premières lames flexibles 26, 27.

Dans le quatrième mode de réalisation de la figure 5, la masse oscillante 32 comprend un bras principal, une première masselotte 34 à une première extrémité, et une deuxième masselotte 35 à une deuxième extrémité, cette deuxième masselotte 35 formant un coude rigide replié sous le bras principal.

Le résonateur comprend un guidage flexible muni d'une première lame flexible 36 reliant la masse oscillante 32 à l'embase 33, depuis l'extrémité du coude replié, la première lame flexible 36 s'étendant dans la canal oblique 39 jusqu'au deuxième point d'encastrement au fond du canal oblique 39.

Le guidage flexible comprend une deuxième lame flexible 37 s'étendant parallèlement au bras de la masse oscillante 32, depuis un premier coin de l'embase 33 jusqu'à un point d'encastrement à l'intérieur du coude replié de la masse oscillante 32. La deuxième lame flexible 37 est agencée au-dessus de la première lame flexible 36.

L'embase 33 a un premier point d'encastrement de la deuxième lame flexible 37, au niveau de la première masselotte 34, et un deuxième point d'encastrement agencé ici à 45° en sens antihoraire (valeur non-limitative), relié à la première lame flexible 36. Le deuxième point d'encastrement est agencé dans un canal oblique 38 ouvert depuis un premier coin de l'embase 33.

La première lame flexible 36 et la deuxième lame flexible 37 s'étendent de manière à former un angle non nul compris entre 10° et 80°, de préférence compris entre 30° et 60°, voire compris entre 40° et 50°.

Les deux lames flexibles 36, 37 comportent un matériau piézoélectrique, disposé ici en totalité sur la deuxième lame flexible 37, et en partie sur la première lame flexible 36. L'actionnement des lames flexibles 36, 37 est identique à celui des modes de réalisation précédents, grâce à des contacts électriques non représentés sur les figures.

La configuration de ce mode de réalisation est différente des autres modes de réalisation, mais la masse oscillante 32 oscille de manière semblable, c'est-à-dire autour d'un axe situé à l'intersection des fibres neutres des deux lames flexibles 36, 37.

Dans le cinquième mode de réalisation d'un résonateur piézoélectrique 40 de la figure 6, en dehors de l'invention, masse oscillante 42 comprenant un bras reliant deux masselottes 44, 45. L'embase 43 a une forme rectangulaire.

Le résonateur 40 comprend une première lame flexible 46 en forme de U, reliant la masse oscillante 42 à l'embase 43. Le U est disposé parallèlement au bras et à l'embase 43. Une première extrémité 48 du U est reliée à l'embase 43, et une deuxième extrémité 49 du U, s'étendant plus loin du centre que la première extrémité 48, est reliée à une masselotte 45 de la masse oscillante 42.

La première lame flexible 46 en U comprend un matériau piézoélectrique, de préférence sur toute sa longueur.

Le résonateur comporte encore une deuxième lame flexible 47 formant une lame de cliquet actif. La deuxième lame flexible 47 est disposée de l'autre côté du bras par rapport à la première lame flexible 46. De préférence, la deuxième lame flexible 47 ne comporte pas de matériau piézoélectrique.

En actionnant électriquement la première lame flexible 46 en U, la masse oscillante 42 et les masselottes 44, 45 oscillent autour d'un centre de rotation. De préférence, le centre de rotation est agencé sur le centre de gravité de la masse oscillante 42. L'actionnement de la première lame flexible 46 est effectuée grâce à des contacts électriques montés sur l'embase 43, non représentés sur les figures.

Les résonateurs 1, 10, 20, 30 selon les modes de réalisation décrits précédemment, comportent, de préférence majoritairement, un matériau mono-cristallin ou poly-cristallin, tels que le silicium, le verre, la céramique, ou un métal.

Les résonateurs 1, 10, 20, 30 sont par exemple obtenus par des procédés photo-lithographiques de micro-usinage de type MEMS (pour micro-electro mechanical systems). Les qualités de rigidité, d'élasticité et la précision d'usinage de tels matériaux confèrent une grande qualité de résonance aux résonateurs 1, 10, 20, 30.

De plus, les caractéristiques d'amagnétisme et de basse conductivité de certains de ces matériaux permettent d'obtenir une excellente résistance aux champs magnétiques continus et alternatifs de valeurs élevées.

En outre, les résonateurs 1, 10, 20, 30 sont configurés pour faire osciller la masse oscillante 2, 12, 22, 32, 42 à la fréquence propre du résonateur 1, 10, 20, 30, 40. Ainsi, on limite la consommation d'énergie du résonateur, notamment en augmentant la course angulaire de la masse oscillante.

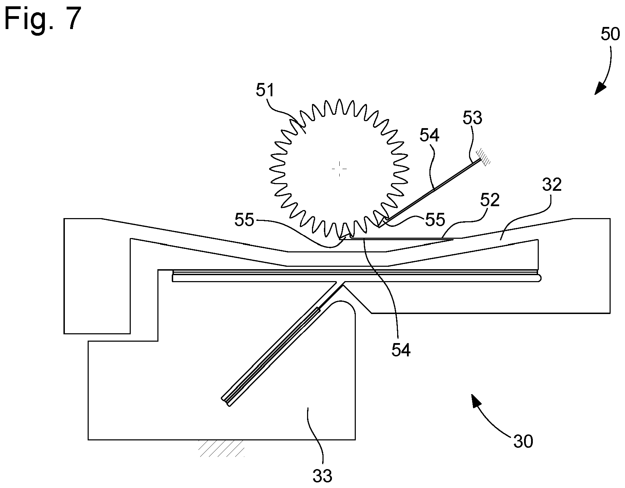

La figure 7 montre un mode de réalisation d'un moteur piézoélectrique 50 rotatif, notamment pour un dispositif d'affichage d'une pièce d'horlogerie.

Le moteur peut notamment servir dans une pièce d'horlogerie pour actionner un dispositif d'affichage, comme des aiguilles agencées sur un cadran. Le moteur piézoélectrique 50 est configuré pour pouvoir tourner et actionner une transmission d'engrenages mécanique du dispositif d'affichage.

Le moteur piézoélectrique 50 comprend un résonateur piézoélectrique selon l'invention, ici le résonateur piézoélectrique 30 du quatrième mode de réalisation de la figure 5. Les autres modes de réalisation de résonateur piézoélectrique peuvent également être utilisés sans que cela change le fonctionnement du moteur piézoélectrique 50. Le résonateur piézoélectrique 30 est assemblé à une platine par son embase 33.

Le moteur piézoélectrique 50 comprend en outre une roue mobile 51 dentée et deux cliquets 52, 53 configurés pour faire tourner la roue mobile 51 dans un seul sens. La roue mobile 51 comprend de préférence une denture périphérique, de préférence asymétrique, et qui définit le sens de rotation. La roue mobile 50 est reliée à un rouage muni d'aiguilles du dispositif d'affichage.

Le premier cliquet 52 est actif et a pour fonction de faire tourner la roue mobile 51 dans un sens antihoraire, tandis que le deuxième cliquet 53 est passif et retient la roue mobile 51, lorsque la roue mobile 51 a tourné, pendant que le premier cliquet 52 actif se réarme sur la dent suivante du rotor.

Chaque cliquet 52, 53 comporte une lame flexible 54 munie d'une dent 55, de préférence asymétrique, à son extrémité.

La rotation de la roue mobile 51 est engendrée grâce au déplacement du premier cliquet actif 52. Le premier cliquet 52 est monté sur la masse oscillante 32 du résonateur piézoélectrique 30. Ainsi, lorsque le résonateur oscille, le premier cliquet 52 oscille également, de sorte qu'il pousse ou tire la roue mobile 51 dentée dans un premier sens selon le positionnement du résonateur piézoélectrique par rapport à la roue mobile 51.

Le deuxième cliquet 53 est soit assemblé directement sur la platine ou sur un pont de platine, ou plus avantageusement de façon solidaire de l'embase 30 pour limiter l'erreur de positionnement dû à l'enchaînement des tolérances d'assemblage. Il a pour fonction d'empêcher la roue dentée de tourner dans le sens opposé au premier sens. La dent 55 du deuxième cliquet 53 est configurée pour coopérer avec la denture asymétrique, de manière à laisser la roue mobile 51tourner dans le premier sens, et à la bloquer dans le sens opposé.

A cette fin, les bras flexibles 54 des cliquets 52, 53 sont en position droite relâchée, lorsque la dent 55 est insérée au fond de la denture de la roue dentée 51, tandis qu'il est armé et courbé, lorsqu'il est repoussé vers l'extérieur par la denture, quand la roue dentée 51 tourne dans le premier sens.

Dans le cas d'une montre, la fréquence de résonance ou fréquence propre du moteur 50 est adaptée à la fréquence du quartz, lequel sert à régler la marche du mouvement. On choisit une fréquence d'excitation correspondant à un sous-multiple de la fréquence du quartz, qui est généralement de 32764 Hz. Par exemple, on choisit une fréquence de 128Hz. La fréquence du moteur 50 est de préférence ajustée et accordée à la fréquence d'excitation de sorte que son amplitude d'oscillation ne descende pas en-dessous de 90-95% de l'amplitude maximale.

De manière optionnelle, le deuxième cliquet 53 peut être configuré pour servir de capteur de pas, afin de déterminer la distance ou la vitesse de rotation de la roue mobile 51. A cette fin, le bras flexible 54 du deuxième cliquet 53 est doté d'un matériau piézoélectrique relié à une unité de comptage. Ainsi, à chaque courbure du deuxième cliquet 53, l'unité de comptage enregistre une rotation de la roue mobile 51 d'une dent.

On comprendra que diverses modifications et/ou améliorations et/ou combinaisons évidentes pour l'homme du métier peuvent être apportées aux différentes formes d'exécution de l'invention exposée ci-dessus sans sortir du cadre de l'invention définie par les revendications annexées.

## Revendications

1. Résonateur piézoélectrique (1, 10, 20, 30), notamment pour moteur piézoélectrique rotatif, le résonateur (1, 10, 20, 30) comprenant une embase (3, 13, 23, 33) immobile et une masse oscillante (2, 12, 22, 32) s'étendant autour d'un axe longitudinal, la masse oscillante (2, 12, 22, 32) étant munie d'au moins une masselotte (4, 14, 24, 34), de préférence deux masselottes (4, 14, 24, 34, 35) opposées, et un guidage à lames flexibles reliant la masse oscillante (2, 12, 22, 32) à l'embase (3, 13, 23, 33), de manière à pouvoir faire osciller la masse oscillante (2, 12, 22, 32) autour d'un centre de rotation dans un mouvement de balancier, ledit guidage comprenant au moins une première lame flexible (6, 16, 26, 36) reliant l'embase (3, 13, 23, 33) à la masse oscillante (2, 12, 22, 32), la première lame flexible (6, 16, 26, 36) comportant au moins en partie un matériau piézoélectrique actionnable électriquement pour déformer la première lame flexible (6, 16, 26, 36) et faire osciller la masse oscillante (2, 12, 22, 32), **caractérisé en ce que** le guidage comporte une deuxième lame flexible (7, 17, 27, 37) reliant la masse oscillante (2, 12, 22, 32) à l'embase (3, 13, 23, 33).

2. Résonateur piézoélectrique selon la revendication 1, dans lequel le centre de rotation est agencé sensiblement au milieu de la masse oscillante (2, 12, 22, 32), de préférence au centre de masse de la masse oscillante.

3. Résonateur piézoélectrique selon la revendication 1 ou 2, dans lequel la deuxième lame flexible (7, 17, 37) comporte au moins en partie un matériau piézoélectrique actionnable électriquement pour déformer la deuxième lame flexible (7, 17, 37) et faire osciller la masse oscillante (2, 12, 22, 32).

4. Résonateur piézoélectrique selon la revendication 3, dans lequel la première lame flexible (6, 16, 26, 36) et la deuxième lame flexible (7, 17, 27, 37) forment un angle compris entre 30° et 150°, de préférence entre 60° et 130°, voire entre 90° et 120°.

5. Résonateur piézoélectrique selon la revendication 4, dans lequel la première lame flexible (6, 16) et la deuxième lame flexible (7, 17) sont décroisées et s'écartent depuis une partie centrale de la masse oscillante (2, 12) jusqu'à des parties excentrées de l'embase (3, 13).

6. Résonateur piézoélectrique selon la revendication 1 ou 2, comprenant une troisième lame flexible (28), la deuxième lame flexible (27) et la troisième lame flexible (28) étant décroisées et s'écartent depuis une partie centrale de la masse oscillante (2, 12) jusqu'à des parties excentrées de l'embase (3, 13).

7. Résonateur piézoélectrique selon la revendication 6, dans lequel la deuxième lame flexible (27) et la troisième lame flexible (28) forment un angle compris entre 30° et 150°, de préférence entre 60° et 130°, voire entre 90° et 120°.

8. Résonateur piézoélectrique selon la revendication 7, dans lequel la première lame flexible (26) est agencée entre la deuxième lame flexible (27) et la troisième lame flexible (28).

9. Résonateur piézoélectrique selon la revendication 8, dans lequel la première lame flexible (26) est plus proche de la deuxième lame flexible (27) que de la troisième lame flexible (28).

10. Résonateur piézoélectrique selon la revendication 8 ou 9, dans lequel la première lame flexible (26) comprend en outre une portion rigide (31).

11. Résonateur piézoélectrique selon l'une, quelconque, des revendications 1 à 3, dans lequel la masse oscillante (32) comprend une masselotte (35) repliée en forme de coude.

12. Résonateur piézoélectrique selon la revendication 11, dans lequel la première lame flexible (36) est oblique et reliée à l'extrémité de la masselotte (35) repliée en forme de coude.

13. Résonateur piézoélectrique selon la revendication 11, dans lequel la deuxième lame flexible (37) est sensiblement parallèle à l'axe longitudinal de la masse oscillante (32), et est reliée à l'intérieur du coude de la masselotte (35).

14. Résonateur piézoélectrique selon l'une, quelconque, des revendications 11 à 13, dans lequel la première lame flexible (36) et la deuxième lame flexible (37) forment un angle compris entre 10 et 90°, de préférence entre 30° et 60°.

15. Résonateur piézoélectrique selon l'une, quelconque, des revendications précédentes, **caractérisé en ce qu'**il est agencé sensiblement dans un même plan.

16. Résonateur piézoélectrique selon l'une, quelconque, des revendications précédentes, **caractérisé en ce qu'**il est configuré pour faire osciller la masse oscillante (2, 12, 22, 32) à la fréquence propre du résonateur (1, 10, 20, 30).

17. Résonateur selon l'une, quelconque, des revendications précédentes, comportant, de préférence majoritairement, un matériau mono-cristallin ou poly-cristallin amagnétique et de basse conductivité, tels que le silicium, le verre, la céramique, ou un métal, et obtenu par exemple par un procédé photo-lithographique de micro-usinage de type MEMS.

18. Moteur piézoélectrique (50), notamment pour un dispositif d'affichage d'une pièce d'horlogerie, **caractérisé en ce que** le moteur piézoélectrique comprend un résonateur piézoélectrique (1, 10, 20, 30) selon l'une, quelconque, des revendications précédentes.

19. Moteur piézoélectrique selon la revendication 18, comprenant au moins un cliquet (52), de préférence deux cliquets (52, 53), et une roue mobile (51), le cliquet (52) étant monté sur la masse oscillante (32) du résonateur piézoélectrique (1), de manière à faire tourner la roue mobile (51) dans un premier sens, lorsque la masse oscillante (32) effectue ses oscillations.

20. Pièce d'horlogerie comportant un mouvement d'horlogerie comprenant une transmission d'engrenages configurée pour faire tourner au moins une aiguille, **caractérisé en ce qu'**elle comprend un résonateur piézoélectrique (1, 10, 20, 30) selon l'une, quelconque, des revendications 1 à 17 ou un moteur piézoélectrique (50) selon l'une, quelconque, des revendications 18 à 19, le moteur piézoélectrique (50) étant agencé pour actionner la transmission d'engrenages.

## Patentansprüche

1. Piezoelektrischer Resonator (1, 10, 20, 30), insbesondere für einen piezoelektrischen Drehmotor, wobei der Resonator (1, 10, 20, 30) eine ortsfeste Basis (3, 13, 23, 33) und eine sich um eine Längsachse herum erstreckende Schwingmasse (2, 12, 22, 32) umfasst, wobei die Schwingmasse (2, 12, 22, 32) mit mindestens einem Massestück (4, 14, 24, 34), vorzugsweise zwei gegenüberliegenden Massestücken (4, 14, 24, 34, 35), versehen ist und der Resonator eine Führung mit flexiblen Lamellen umfasst, die die Schwingmasse (2, 12, 22, 32) mit der Basis (3, 13, 10, 23, 33) verbindet, sodass die Schwingmasse (2, 12, 22, 32) um ein Rotationszentrum in einer Pendelbewegung schwingen kann, wobei die Führung mindestens eine erste flexible Lamelle (6, 16, 26, 36) umfasst, die die Basis (3, 13, 23, 33) mit der Schwingmasse (2, 12, 22, 32) verbindet, wobei die erste flexible Lamelle (6, 16, 26, 36) zumindest teilweise ein elektrisch ansteuerbares piezoelektrisches Material aufweist, um die erste flexible Lamelle (6, 16, 26, 36) zu verformen und die Schwingmasse (2, 12, 22, 32) zum Schwingen zu bringen,
**dadurch gekennzeichnet, dass** die Führung
eine zweite flexible Lamelle (7, 17, 27, 37) umfasst, die die Schwingmasse (2, 12, 22, ³²) mit der Basis (3, 13, 23, 33) verbindet.

2. Piezoelektrischer Resonator nach Anspruch 1, wobei das Rotationszentrum im Wesentlichen in der Mitte der Schwingmasse (2, 12, 22, 32), vorzugsweise im Schwerpunkt der Schwingmasse, angeordnet ist.

3. Piezoelektrischer Resonator nach Anspruch 1 oder 2, wobei die zweite flexible Lamelle (7, 17, 37) zumindest teilweise ein elektrisch ansteuerbares piezoelektrisches Material aufweist, um die zweite flexible Lamelle (7, 17, 37) zu verformen und die Schwingmasse (2, 12, 22, 32) zum Schwingen zu bringen.

4. Piezoelektrischer Resonator nach Anspruch 3, wobei die erste flexible Lamelle (6, 16, 26, 36) und die zweite flexible Lamelle (7, 17, 27, 37) einen Winkel zwischen 30° und 150°, vorzugsweise zwischen 60° und 130°, insbesondere zwischen 90° und 120°, einschließen.

5. Piezoelektrischer Resonator nach Anspruch 4, wobei die erste flexible Lamelle (6, 16) und die zweite flexible Lamelle (7, 17) ungekreuzt sind und von einem zentralen Teil der Schwingmasse (2, 12) zu exzentrischen Teilen der Basis (3, 13) auseinanderlaufen.

6. Piezoelektrischer Resonator nach Anspruch 1 oder 2, umfassend eine dritte flexible Lamelle (28), wobei die zweite flexible Lamelle (27) und die dritte flexible Lamelle (28) ungekreuzt sind und von einem zentralen Teil der Schwingmasse (2, 12) zu exzentrischen Teilen der Basis (3, 13) auseinanderlaufen.

7. Piezoelektrischer Resonator nach Anspruch 6, wobei die zweite flexible Lamelle (27) und die dritte flexible Lamelle (28) einen Winkel zwischen 30° und 150°, vorzugsweise zwischen 60° und 130°, insbesondere zwischen 90° und 120°, einschließen.

8. Piezoelektrischer Resonator nach Anspruch 7, wobei die erste flexible Lamelle (26) zwischen der zweiten flexiblen Lamelle (27) und der dritten flexiblen Lamelle (28) angeordnet ist.

9. Piezoelektrischer Resonator nach Anspruch 8, wobei die erste flexible Lamelle (26) näher an der zweiten flexiblen Lamelle (27) als an der dritten flexiblen Lamelle (28) angeordnet ist.

10. Piezoelektrischer Resonator nach Anspruch 8 oder 9, wobei die erste flexible Lamelle (26) ferner einen starren Abschnitt (31) umfasst.

11. Piezoelektrischer Resonator nach einem beliebigen der Ansprüche 1 bis 3, wobei die Schwingmasse (32) ein winkelförmig umgebogenes Massestück (35) umfasst.

12. Piezoelektrischer Resonator nach Anspruch 11, wobei die erste flexible Lamelle (36) schräg angeordnet ist und mit dem Ende des winkelförmig umgebogenen Massestücks (35) verbunden ist.

13. Piezoelektrischer Resonator nach Anspruch 11, wobei die zweite flexible Lamelle (37) im Wesentlichen parallel zur Längsachse der Schwingmasse (32) angeordnet ist und mit der Innenseite der winkelförmigen Biegung des Massestücks (35) verbunden ist.

14. Piezoelektrischer Resonator nach einem beliebigen der Ansprüche 11 bis 13, wobei die erste flexible Lamelle (36) und die zweite flexible Lamelle (37) einen Winkel zwischen 10° und 90°, vorzugsweise zwischen 30° und 60°, einschließen.

15. Piezoelektrischer Resonator nach einem der vorhergehenden Ansprüche, **dadurch gekennzeichnet, dass** er im Wesentlichen in derselben Ebene angeordnet ist.

16. Piezoelektrischer Resonator nach einem der vorhergehenden Ansprüche, **dadurch gekennzeichnet, dass** er dazu eingerichtet ist, die Schwingmasse (2, 12, 22, 32) mit der Eigenfrequenz des Resonators (1, 10, 20, 30) schwingen zu lassen.

17. Resonator nach einem der vorhergehenden Ansprüche, wobei er vorzugsweise überwiegend ein einkristallines oder polykristallines, amagnetisches Material geringer elektrischer Leitfähigkeit umfasst, wie Silizium, Glas, Keramik oder ein Metall, und beispielsweise durch ein photolithographisches Mikrobearbeitungsverfahren vom MEMS-Typ erhalten ist.

18. Piezoelektrischer Motor (50), insbesondere für eine Anzeigevorrichtung einer Uhr, **dadurch gekennzeichnet, dass** der piezoelektrische Motor einen piezoelektrischen Resonator (1, 10, 20, 30) nach einem der vorhergehenden Ansprüche umfasst.

19. Piezoelektrischer Motor nach Anspruch 18, umfassend mindestens eine Klinke (52), vorzugsweise zwei Klinken (52, 53), und ein bewegliches Rad (51), wobei die Klinke (52) auf der Schwingmasse (32) des piezoelektrischen Resonators (1) montiert ist, um das bewegliche Rad (51) in einem ersten Drehsinn zu drehen, wenn die Schwingmasse (32) ihre Schwingungen ausführt.

20. Uhr mit einem Uhrwerk, umfassend ein Zahnradgetriebe, das dazu eingerichtet ist, mindestens einen Zeiger zu drehen, **dadurch gekennzeichnet, dass** die Uhr einen piezoelektrischen Resonator (1, 10, 20, 30) nach einem der Ansprüche 1 bis 17 oder einen piezoelektrischen Motor (50) umfasst nach einem der Ansprüche 18 bis 19, wobei der piezoelektrische Motor (50) dazu angeordnet ist, das Zahnradgetriebe anzutreiben.

## Claims

1. Piezoelectric resonator (1, 10, 20, 30), in particular for a piezoelectric rotary motor, the resonator (1, 10, 20, 30) comprising a stationary base (3, 13, 23, 33) and an oscillating mass (2, 12, 22, 32) extending about a longitudinal axis, the oscillating mass (2, 12, 22, 32) being provided with at least one flyweight (4, 14, 24, 34), preferably two opposing flyweights (4, 14, 24, 34, 35), and a flexible blade guide connecting the oscillating mass (2, 12, 22, 32) to the base (3, 13, 23, 33), so as to be able to oscillate the oscillating weight (2, 12, 22, 32) about a centre of rotation in a pendulum movement, said guide comprising at least one first flexible blade (6, 16, 26, 36) connecting the base (3, 13, 23, 33) to the oscillating weight (2, 12, 22, 32), the first flexible blade (6, 16, 26, 36) including at least in part an electrically actuable piezoelectric material for deforming the first flexible blade (6, 16, 26, 36) and oscillating the oscillating weight (2, 12, 22, 32), **characterized in that** the guide comprises a second flexible blade (7, 17, 27, 37) connecting the oscillating mass (2, 12, 22, 32) to the base (3, 13, 23, 33).

2. A piezoelectric resonator as claimed in claim 1, in which the centre of rotation is arranged substantially in the centre of the oscillating mass (2, 12, 22, 32), preferably in the centre of mass of the oscillating mass.

3. A piezoelectric resonator as claimed in claim 1 or 2, wherein the second flexible blade (7, 17, 37) comprises at least in part an electrically actuable piezoelectric material for deforming the second flexible blade (7, 17, 37) and oscillating the oscillating mass (2, 12, 22, 32).

4. Piezoelectric resonator according to claim 3, in which the first flexible blade (6, 16, 26, 36) and the second flexible blade (7, 17, 27, 37) form an angle of between 30° and 150°, preferably between 60° and 130°, or even between 90° and 120°.

5. A piezoelectric resonator as claimed in claim 4, wherein the first flexible blade (6, 16) and the second flexible blade (7, 17) are uncrossed and extend from a central portion of the oscillating mass (2, 12) to eccentric portions of the base (3, 13).

6. A piezoelectric resonator as claimed in claim 1 or 2, comprising a third flexible blade (28), the second flexible blade (27) and the third flexible blade (28) being uncrossed and extending from a central portion of the oscillating mass (2, 12) to eccentric portions of the base (3, 13).

7. Piezoelectric resonator according to claim 6, in which the second flexible blade (27) and the third flexible blade (28) form an angle of between 30° and 150°, preferably between 60° and 130°, or even between 90° and 120°.

8. A piezoelectric resonator as claimed in claim 7, wherein the first flexible blade (26) is arranged between the second flexible blade (27) and the third flexible blade (28).

9. The piezoelectric resonator of claim 8, wherein the first flexible blade (26) is closer to the second flexible blade (27) than to the third flexible blade (28).

10. A piezoelectric resonator as claimed in claim 8 or 9, wherein the first flexible blade (26) further comprises a rigid portion (31).

11. A piezoelectric resonator according to any one of claims 1 to 3, wherein the oscillating mass (32) comprises a flyweight (35) bent in the shape of an elbow.

12. A piezoelectric resonator as claimed in claim 11, in which the first flexible blade (36) is oblique and connected to the end of the flyweight (35) bent in the shape of an elbow.

13. A piezoelectric resonator as claimed in claim 11, in which the second flexible blade (37) is substantially parallel to the longitudinal axis of the oscillating mass (32), and is connected to the inside of the elbow of the flyweight (35).

14. Piezoelectric resonator according to any one of claims 11 to 13, in which the first flexible blade (36) and the second flexible blade (37) form an angle of between 10° and 90°, preferably between 30° and 60°.

15. Piezoelectric resonator according to any one of the preceding claims, **characterised in that** it is arranged substantially in the same plane.

16. Piezoelectric resonator according to any one of the preceding claims, **characterised in that** it is configured to cause the oscillating mass (2, 12, 22, 32) to oscillate at the natural frequency of the resonator (1, 10, 20, 30).

17. Resonator according to any one of the preceding claims, preferably comprising, for the most part, a non-magnetic monocrystalline or polycrystalline material with low conductivity, such as silicon, glass, ceramic or a metal, and obtained for example by a MEMS-type photolithographic micromachining process.

18. A piezoelectric motor (50), in particular for a display device of a timepiece, **characterised in that** the piezoelectric motor comprises a piezoelectric resonator (1, 10, 20, 30) according to any one of the preceding claims.

19. A piezoelectric motor according to claim 18, comprising at least one pawl (52), preferably two pawls (52, 53), and a moving wheel (51), the pawl (52) being mounted on the oscillating mass (32) of the piezoelectric resonator (1) so as to rotate the moving wheel (51) in a first direction when the oscillating mass (32) performs its oscillations.

20. A timepiece having a timepiece movement comprising a gear transmission configured to rotate at least one hand, **characterised in that** it comprises a piezoelectric resonator (1, 10, 20, 30) according to any one of claims 1 to 17 or a piezoelectric motor (50) according to any one of claims 18 to 19, the piezoelectric motor (50) being arranged to actuate the gear transmission.
